# EUROPEAN PATENT APPLICATION

(11) **EP 1 916 774 A1**
(43) Date of publication of application: **30.04.2008**
(21) Application number: 06445069.5
(22) Date of filing: 27.10.2006
(51) Int. Cl.: H04B 1/18

(54) **Antenna device and portable radio communication device comprising such antenna device**

(71) Applicant: Laird Technologies AB, 184 25 Åkersberga (SE)
(72) Inventor: Von Arbin, Axel, 183 63 Täby (SE); Kaikkonen, Andrei, 164 71 Kista (SE); Lindberg, Peter, 752 29 Uppsala (SE)
(74) Representative: Estreen, Lars J.F.

(57) **Abstract**

An antenna device for a portable radio communication device adapted for receiving radio signals comprises a radiating element (10) and an amplifier stage (30) with a transistor (31) with a gate, a source, and a drain, said transistor having a minimum noise figure below 1 dB and a gain above 15 dB in the first operating frequency band. The source of the transistor is connected directly to ground. By providing a transistor with these characteristics in this way, stable operation is achieved with high gain amplification.

## Description

### FIELD OF INVENTION

The present invention relates generally to antenna devices and more particularly to an antenna device for use in a radio communication device, such as a mobile phone, which is adapted for radio signals having a relatively low frequency, such as radio signals in the FM band.

### BACKGROUND

Internal antennas have been used for some time in portable radio communication devices. There are a number of advantages connected with using internal antennas, of which can be mentioned that they are small and light, making them suitable for applications wherein size and weight are of importance, such as in mobile phones.

However, the application of internal antennas in a mobile phone puts some constraints on the configuration of the antenna element. In particular, in a portable radio communication device the space for an internal antenna arrangement is limited. These constraints may make it difficult to find a configuration of the antenna that provides for a wide operating band. This is especially true for antennas intended for use with radio signals of relatively low frequencies as the desired physical length of such antennas are large compared to antennas operating with relatively high frequencies.

One specific application operating in a relatively low frequency band is the FM radio application. The FM band is defined as frequencies between 88-108 MHz in Europe or between 76-110 MHz in the USA. Prior art conventional antenna configurations, such as loop antennas or monopole antennas, fitted within the casing of a portable radio communication device will result in unsatisfactory operation in that the antenna either has too bad performance over a sufficiently wide frequency band or sufficient performance over a too narrow frequency band.

Instead, a conventional FM antenna for portable radio communication devices is provided in the headset wire connected to the communication device. This configuration with a relatively long wire permits an antenna length that is sufficient also for low frequency applications. However, if no external antenna is permitted this solution is obviously not feasible.

Another problem is that in case a second antenna, such as a GSM antenna, is provided in the same communication device as the FM antenna, this second antenna interferes with the operation of the FM antenna.

### SUMMARY OF THE INVENTION

An object of the present invention is to provide an internal antenna device for use in a portable radio communication device, which operates with sufficient performance throughout a frequency band having a relatively low frequency, such as the FM radio band.

The invention is based on the realization that careful choice of amplifier stage, combined with a filter, provides an antenna device having advantageous characteristics.

According to the present invention there is provided an antenna device for a portable radio communication device adapted for receiving radio signals in at least a first operating frequency band, said antenna device comprising a radiating element comprising a feeding portion, an amplifier stage connected to the feeding portion of the radiating element and connectable to a receiver device for radio signals, a filter stage connected between the radiating element and the amplifier, characterized in that the amplifier comprises a transistor with a gate, a source, and a drain, said transistor having a minimum noise figure below 1 dB and a gain above 15 dB in the first operating frequency band, wherein the source of the transistor is connected directly to ground, the gate of the transistor is connected to the filter stage, the drain of the transistor is connectable to the receiver device for radio signals, a resistor is connected between the drain of the transistor and a feed voltage, and wherein in operation, the filter stage blocks signals having a frequency above the first operating frequency band and allows signals in the first operating frequency band.

A portable radio communication device comprising such an antenna device is also provided.

The antenna device according to the invention provides stable operation while giving high gain amplification, resulting in a relatively strong low noise RF signal reaching the receiver device for radio signals.

In a preferred embodiment, a so-called cascode configuration is used. With this configuration, high isolation between input and output of the amplifier stage with high gain is achieved, ensuring stable amplifier operation. Furthermore, the small input capacitance provides a broadband solution.

Further preferred embodiments are defined in the dependent claims.

### BRIEF DESCRIPTION OF DRAWINGS

The invention is now described, by way of example, with reference to the accompanying drawings, in which:
FIG. 1 is a schematic diagram showing an antenna device according to the invention connected to an FM receiver circuit;
FIG. 2 is a diagram showing in more detail a first embodiment of an antenna device according to the invention;
FIG. 3 is a diagram showing a second embodiment of an antenna device according to the invention;
FIG. 4 is a diagram showing a third embodiment of an antenna device according to the invention;
FIG. 5 is a perspective partially cut-away view of an antenna device according to the invention mounted in a portable radio communication device; and
FIG. 6 is a schematic diagram showing the use of a matching network between the antenna device and the FM receiver circuit.

### DETAILED DESCRIPTION OF THE INVENTION

In the following, a detailed description of preferred embodiments of an antenna device and a portable radio communication device according to the invention will be given.

In the following description and claims, the term radiating element is used. It is to be understood that this term is intended to cover electrically conductive elements arranged for receiving radio signals.

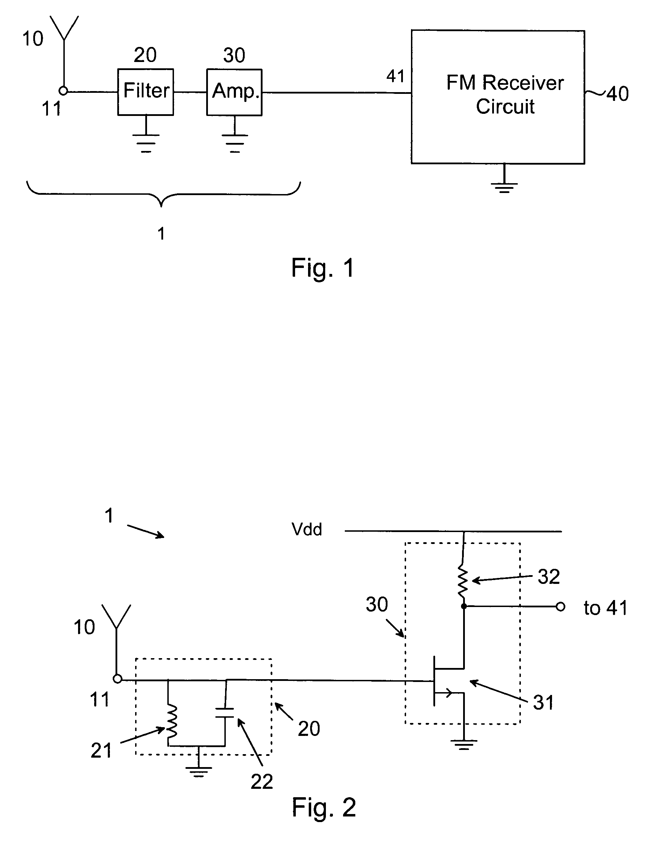

First with reference to FIG. 1, the general configuration of an antenna device 1 according to the invention is shown. It comprises a radiating element 10 in the form of a non-resonant piece of electrically conductive material, such as sheet metal or flex film. An example of the size thereof is 30 times 10 millimeters, placed on the back cover of a portable radio communication device. The radiating element has a feeding portion 11 connected to a filter stage 20 arranged to block signals having a frequency above the operating frequency band and to allow signals in the operating frequency band. It is preferred that the filter stage acts as a band pass filter for signals in the operating frequency band. In the case of operation in the FM band, the pass band is between 88-108 MHz in Europe or between 76-110 MHz in the USA.

The function of the filter stage 20 is to act as ESD protection circuit, effectively blocking the major part of ESD pulse spectrum. The filter also eliminates or at least reduces interference from electro magnetic interference (EMI) signals and possibly signals from other antennas provided in the same radio communication device, such as cellular GSM antennas operating at frequencies well above the FM antenna.

An amplifier stage 30 is arranged after the filter stage for amplifying signals received by the radiating element 10.

Signals received and amplified by the antenna device 1 are supplied to an FM receiver circuit 40, which could be a conventional circuit manufactured by Philips Semiconductors and sold under the name HVQFN40. The FM receiver circuit comprises an RF input 41, which is connected to the amplifier 30.

It is preferred that the filter and amplifier stages are provided relatively close to the radiating element 10 in order to minimize parasitic effects and interference from external sources.

An implementation of the general idea expressed in FIG. 1 will now be described with reference to FIG. 2. The filter stage 20 is here implemented as a grounded LC circuit comprising an inductor 21 and a capacitor 22 connected in parallel and between the feeding portion 11 and ground. In one embodiment, the inductance of inductor 21 is approximately 40 nH and the capacitance of capacitor 22 is approximately 60 pF.

The amplifier stage 30 comprises a field effect transistor (FET) 31 with the gate connected to the filter 20, the source connected directly to ground and the drain connectable to the input 41 of the FM receiver circuit 40. There is also a load resistor 32 connected between the drain of the transistor 31 and the feed voltage Vdd.

In order for the antenna device 1 to operate, the transistor must have a minimum noise figure below 1 dB and a gain above 15 dB in the operating frequency band. Also, it is preferred that the transistor has a noise resistance Rn of less than 10 Ohms in order to achieve highest possible signal reception quality for arbitrary antenna configurations.

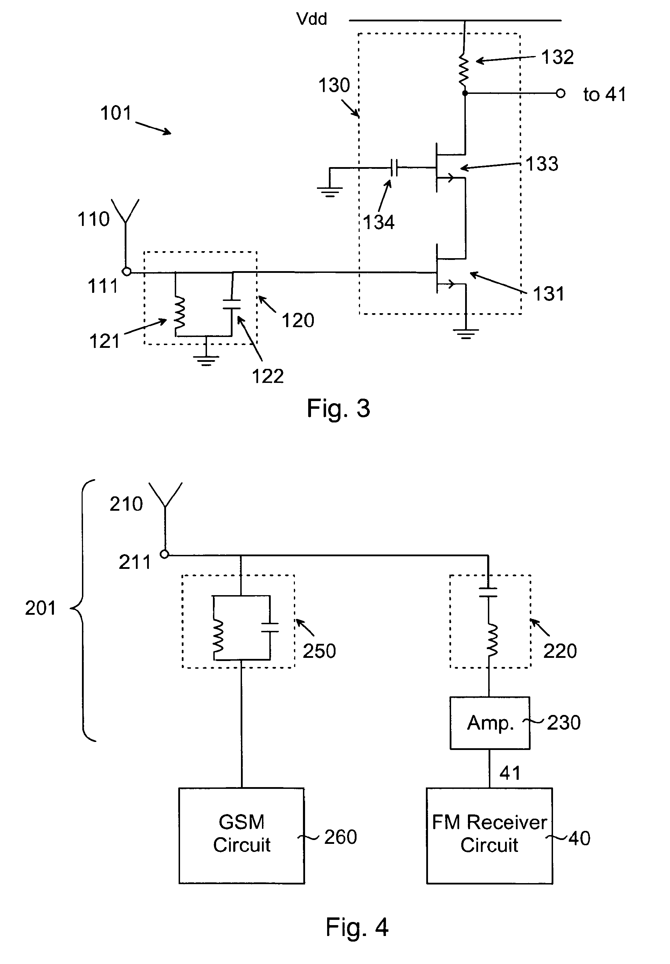

An alternative implementation of the inventive idea in the form of a second embodiment will now be described with reference to FIG. 3. Like the above described first embodiment, this antenna device comprises a radiating element 110 having a feed portion 111 connected to a band pass filter stage 120. However, in this second embodiment the amplifier stage is a so-called cascode amplifier 130. This cascode amplifier comprises a field effect transistor 131 with the gate connected to the filter 120, the source connected directly to ground and the drain connected to the source of a second field effect transistor 133. The gate of the second transistor 133 is connected to ground via a capacitor 134. The drain of the second transistor 133 is connectable to the input 41 of the FM receiver circuit 40. There is also a load resistor 132 connected between the drain of the second transistor 133 and the feed voltage Vdd.

A third embodiment of an antenna device according to the invention will now be described with reference to FIG. 4. A radiating element 210 in the form of a monopole antenna is provided with a feed portion 211 connected to a band pass filter 220 allowing signals in the FM frequency band. In contrast to the above-described embodiments, this band pass filter is ungrounded. The band pass filter 220 is connected to an amplifier stage 230 connectable to the RF input 41 of an FM receiver circuit 40. The amplifier stage could be any of the above described amplifier stages 30 or 130.

The feed portion 211 of the radiating element 210 is also connected to a second filter stage 250. This second filter stage is ungrounded, too, and is arranged to block signals in the FM frequency band and to allow signals in a second frequency band above this FM frequency band, such as signals in a frequency band of a cellular application, e.g., GSM signals. The second filter stage is connectable to transmit and receive circuits of this second frequency band, for example a GSM circuit 260

The antenna device 201 is thus operating in two spaced apart frequency ranges, such as the FM frequency band and one or more GSM frequency bands, using one single radiating element 210.

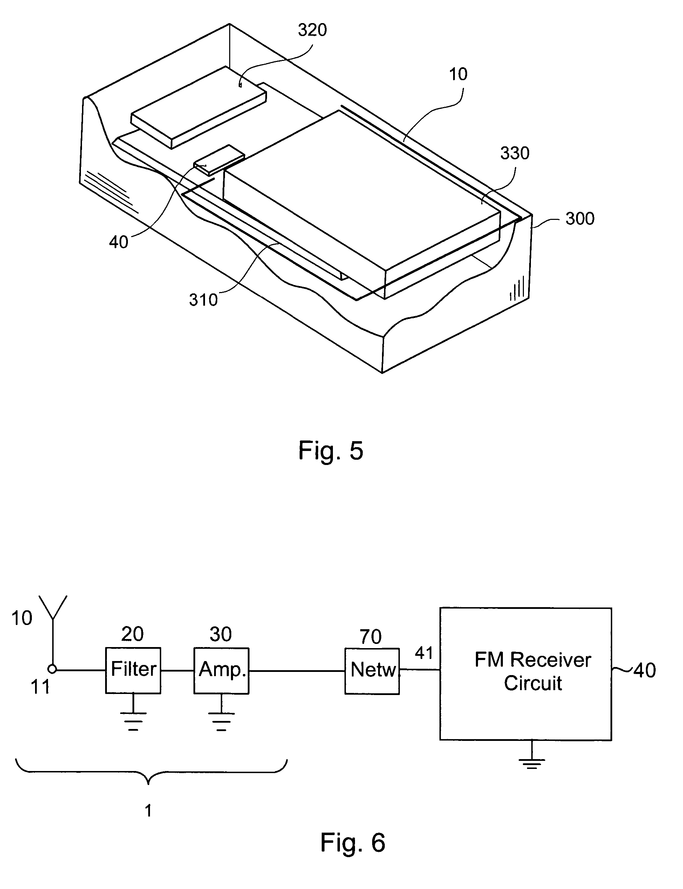

A preferred position of the antenna device according to the invention as described above with reference to FIGs. 1-3 will now be described with reference to FIG. 5, wherein the general outlines of the casing of a portable radio communication device 300, such as a mobile phone, is depicted. The casing is shown partially cut away so as to not obscure the position of the antenna device, which could be any of the devices described with reference to FIGS 1-3.

A printed circuit board (PCB) 310 is provided in the casing, having the circuits (not shown) conventionally found in a mobile phone. On the PCB there is also mounted the FM receiver circuit 40. In the upper portion of the casing there is provided an antenna radiating element 320 for receiving and transmitting RF signals for a cellular mobile phone system, such as a GSM system.

A battery package 330 is also provided towards the back of the casing 300. This battery package is connected to the PCB by means of connectors (not shown). FM antenna radiator is preferably placed on the back cover. The radiator can comprise a thin stripe going around the battery. When the back cover is made of metal, it can directly be utilized as the FM antenna radiator element. Alternatively, a headset cable can be used as the FM antenna radiator element.

A schematic diagram of yet an alternative embodiment is shown in FIG. 6. In this embodiment, a matching network 70 is provided between the output of the amplifier stage 30 and the FM receiver circuit 40. This network is arranged for matching high output amplifier impedance to a 50 Ohms interface in order to realize higher gain, for example.

Preferred embodiments of an antenna device according to the invention have been described. However, the person skilled in the art realizes that these can be varied within the scope of the appended claims without departing from the inventive idea.

It is realized that the shape and size of the antenna device according to the invention can be varied within the scope defined by the appended claims. Thus, the exact antenna configurations can be varied so as to correspond to the shape of the radio communication device, desired performance etc.

The above-described embodiments of an antenna device according to the invention have been described as antenna devices adapted for reception of radio signals in the FM frequency band. However, other applications are also possible, such as use for digital video broadcasting (DVB) signals in the frequency range of about 400-800 MHz.

Although an antenna device for a portable radio communication device has been described with reference to its use in a mobile phone, it will be appreciated that the inventive idea is also applicable to other portable radio communication devices, also devices that are portable but primarily intended for stationary use. Examples thereof could be small clocks, such as travel alarm clocks, TV receivers, or game consoles. Yet a possible application of the antenna device according to the invention is in personal digital assistants (PDAs), MP3 and CD players, FM radio receivers, and laptop computers. A further application is in cars. Thus, the term portable radio communication device should be construed in a broad sense.

The filter stages 20, 120, and 220 have been described as band pass filters. It will be appreciated that they could also be provided as low pass filters blocking signals having a frequency above the operating frequency band and allowing signals in the operating frequency band.

The embodiment described above with reference to FIG. 4 includes a GSM antenna. It will be appreciated that this could be substituted for a different antenna as long as its operating frequency is well above that of the lower frequency band, such as the FM band. A second antenna can also be omitted.

## Claims

1. An antenna device for a portable radio communication device adapted for receiving radio signals in at least a first operating frequency band, said antenna device comprising
- a radiating element (10; 110; 210) comprising a feeding portion (11; 111; 211),
- an amplifier stage (30; 130; 230) connected to the feeding portion of the radiating element and connectable to a receiver device for radio signals (40),
- a filter stage (20; 120; 220) connected between the radiating element and the amplifier,
**characterized in that**
- the amplifier comprises a transistor (31; 131) with a gate, a source, and a drain, said transistor having a minimum noise figure below 1 dB and a gain above 15 dB in the first operating frequency band, wherein
- the source of the transistor is connected directly to ground,
- the gate of the transistor is connected to the filter stage,
- the drain of the transistor is connectable to the receiver device for radio signals (40),
- a resistor (32; 132) is connected between the drain of the transistor and a feed voltage (V_{DD}), and wherein
- in operation, the filter stage blocks signals having a frequency above the first operating frequency band and allows signals in the first operating frequency band.

2. The antenna device according to claim 1, comprising a second transistor (133) provided between the drain of the transistor (131) and the resistor (132), wherein the source of the second transistor is connected to the drain of the transistor, the gate of the second transistor is connected to ground, and the drain of the second transistor is connected to the resistor.

3. The antenna device according to claim 2, comprising a capacitor (134) connected between the gate of the second transistor (133) and ground.

4. The antenna device according to any of claims 1-3, wherein the filter stage (20; 120; 220) is a band pass filter allowing signals in the first operating frequency band and blocking signals above and below the first operating frequency band.

5. The antenna device according to any of claims 1-4, wherein the transistor is a field effect transistor.

6. The antenna device according to any of claims 1-5, wherein the radiating element (10; 110; 210) is non-resonant.

7. The antenna device according to any of claims 1-6, wherein the first operating frequency band is the FM frequency band.

8. The antenna device according to any of claims 1-7, wherein the noise resistance of the transistor (31; 131) is less than 10 Ohms.

9. The antenna device according to any of claims 1-8, wherein the radiating element is a monopole element (210) and the filter stage (230) is ungrounded, the antenna device further comprising a second filter stage (250) which is ungrounded and which during operation blocks signals in the first operating band and to allow signals in a second operating frequency band above the first operating frequency band, the second filter stage being connectable to a circuit (260) arranged to transmit and receive circuits of the second operating frequency band.

10. The antenna device according to any of claims 1-9, wherein the radiating element is comprised in a headset cable.

11. The antenna device according to any of claims 1-9, wherein the radiating element comprises an electrically conductive cover of a portable radio communication device.

12. A portable radio communication device comprising an antenna device according to claim 1.
